# EUROPÄISCHE PATENTANMELDUNG

(11) **EP 3 629 686 A1**
(43) Veröffentlichungstag der Anmeldung: **01.04.2020**
(21) Anmeldenummer: 18196828.0
(22) Anmeldetag: 26.09.2018
(51) Int. Cl.: H05K 7/20

(54) **VORRICHTUNG ZUM ANPRESSEN VON BAUELEMENTEN**

(71) Anmelder: Siemens Aktiengesellschaft, 80333 München (DE)
(72) Erfinder: Petricek, Martin, 2020 Hollabrunn (AT)
(74) Vertreter: Maier, Daniel Oliver

(57) **Zusammenfassung**

Die vorliegende Erfindung betrifft allgemein das Gebiet elektrischer und elektronischer Geräte, insbesondere den Bereich der Schaltnetzteile sowie der leistungselektronischen Schaltungen. Im Speziellen bezieht sich die vorliegende Erfindung auf eine Vorrichtung (1) zum Anpressen von auf einer Trägerplatte (8) angebrachten Bauteilen (7a, 7b) an einen Kühlkörper (9). Dabei erfolgt eine Kühlung der Bauelemente (7a, 7b) durch die Trägerplatte bzw. über eine Kontaktierung der Bauelemente (7a, 7b) mit der Trägerplatte (8). Der Kühlkörper (9) ist dazu an einer zumindest in einem Kühlbereich nicht mit Bauelementen (7a, 7b) bestückten Seite bzw. Unterseite der Trägerplatte (8) angeordnet. Die Vorrichtung (1) zum Anpressen von zumindest einem Bauelement (7a, 7b) umfasst dabei zumindest einen Hohlkörper (2) zum Aufnehmen von zumindest einem Befestigungskörper (10) und zumindest einen Federarm (5, 5a, 5b). Dieser zumindest eine Federarm (5, 5a, 5b) ist gekrümmt ausgeführt und weist an seinem Ende eine Auflagefläche (6, 6a, 6b) zum Übertragen einer Anpresskraft (F) auf das zu kühlendes Bauelement (7a, 7b) auf. Die erfindungsgemäße Vorrichtung (1) kann einfach und rasch - insbesondere automatisiert - montiert werden und ermöglicht eine platzsparende Anordnung von zu kühlenden Bauelemente (7a, 7b) insbesondere unter Einhaltung vorgegebener Spannungsabstände bzw. vorgegebener Luft- und Kriechstrecken.

## Beschreibung

### Technisches Gebiet

Die vorliegende Erfindung betrifft allgemein das Gebiet elektrischer und elektronischer Geräte, insbesondere den Bereich der Schaltnetzteile sowie der leistungselektronischen Schaltungen. Im Speziellen bezieht sich die vorliegende Erfindung auf eine Vorrichtung zum Anpressen von auf einer Trägerplatte angebrachten Bauteilen an einen Kühlkörper. Dabei erfolgt eine Kühlung der Bauelemente über die Trägerplatte bzw. eine Kontaktierung der Bauelemente mit der Trägerplatte. Der Kühlkörper ist dazu an einer zumindest in einem Bereich einer thermischen Kontaktierung bzw. in einem Kühlbereich nicht mit Bauelementen bestückten Seite der Trägerplatte angeordnet.

### Stand der Technik

Geräte, insbesondere elektrische oder elektronische Geräte wie z.B. Schaltnetzteile, leistungselektronische Schaltungen, Steuergeräte, etc. werden heutzutage üblicherweise aus elektrischen Bauelementen und/oder Baugruppen aufgebaut. Die Bauelemente sind dabei auf einer Trägerplatte - einer so genannte Leiterplatte - anbracht, welche einer mechanische Befestigung sowie über so genannte Leiterbahnen einer elektrischen Verbindung der Bauelemente dient. Die Bauelemente können z.B. mittels Anlöten auf Lötflächen oder in Lötaugen, mittels Aufkleben, etc. und bei größeren Bauelementen mittels Verschraubung auf der Leiterplatte befestigt werden.

Häufig umfasst die Schaltung eines Geräts, insbesondere eines elektrischen Geräts, Halbleiterbauelemente wie z.B. Leistungshalbleiterelemente, etc., von welchen eine meist thermische Verlustenergie - d.h. Wärme - produziert wird. Um beispielsweise eine Beschädigung oder ein Überhitzen des jeweiligen Bauelements oder der Schaltung bzw. eine Funktionsstörung des Geräts durch die Verlustleistung bzw. Wärme zu verhindern, ist es notwendig, diese Verlustleistung produzierenden Bauelemente entsprechend zu kühlen bzw. die produzierte Wärme abzuleiten.

Üblicherweise wird dazu die Trägerplatte bzw. Leiterplatte, auf welcher sich die Verlustleistung produzierenden bzw. zu kühlenden Halbleiterbauelemente befinden, mit einem Wärme ableitenden Teil - einem so genannten Kühlkörper - verbunden. Vom Kühlkörper, welcher üblicherweise aus einem gut wärmeleitfähigem Metall, meist Aluminium oder Kupfer besteht, wird eine so genannte Wärmebrücke gebildet, um die entstandene Wärme vom zu kühlenden Bauelement weg zu leiten und z.B. an eine Geräteumgebung abzugeben. Kühlkörper finden beispielsweise in der Leistungselektronik, in Steuergeräten, etc. vor allem zur Kühlung von Leistungshalbleitern (z.B. Leistungsdioden, Leistungstransistoren, etc.) Verwendung.

Bei auf Träger- bzw. Leiterplatten angebrachten Schaltungen kann der Kühlkörper beispielsweise an einer Seite, welche zumindest in einem Bereich von Verlustleistung produzierenden bzw. zu kühlenden Bauelementen - d.h. in einem Kühlbereich - von einer Bestückung mit Bauelementen ausgenommen ist, bzw. an einer Unterseite der Trägerplatte anliegend angeordnet sein. D.h. die von einem Bauelement erzeugte Verlustwärme bzw. Verlustleistung wird dann vom Bauelement durch die Trägerplatte zum Kühlkörper geleitet bzw. die Trägerplatte befindet sich zwischen dem Kühlkörper und einem zu kühlenden Bauelement. Insbesondere bei Träger- bzw. Leiterplatten mit Durchkontaktierungen - d.h. einer vertikalen, elektrischen Verbindung zwischen Leiterbahnebenen der Leiterplatte in Form von innen metallisierten Bohrungen - kann die Ableitung der Wärme auch vom Bauelement über die Durchkontaktierung zum Kühlkörper erfolgen. Bei Schaltungen auf Träger- bzw. Leiterplatten mit Durchkontaktierungen zum Anbringen und Verbinden der Bauelemente werden häufig bei der Montage zur galvanischen Trennung bzw. zur Isolierung zwischen der Trägerplatte bzw. der Durchkontaktierung und dem metallischen Kühlkörper zusätzlich eine elektrisch isolierende Schicht und/oder Isolierungselemente z.B. aus Keramik, Silikongummi oder einem speziellen Kunststoff eingefügt.

Um die Wärmeableitung zu begünstigen, benötigen Kühlkörper eine gute thermische Anbindung an das jeweils zu kühlende Bauelement. Daher ist es notwendig, einen möglichst engen und guten Kontakt zwischen dem Kühlkörper und dem zu kühlenden Bauelement herzustellen. Zum Ausgleich von Unebenheiten z.B. zwischen der Unterseite der Trägerplatte und einer Oberfläche des Kühlkörpers und um einen besseren Wärmeübergang zum Kühlkörper herzustellen, kann vor der Montage z.B. eine dünne Schicht Wärmeleitpaste aufgetragen werden. Bei einer elektrisch isolierenden Montage können die eingefügte elektrisch isolierende Schicht und/oder die Isolierungselemente beispielsweise zum Ausgleichen von Unebenheiten und zur Verbesserung der Wärmeübertragung genutzt werden.

Um den entsprechend engen und guten thermischen Kontakt zwischen dem zu kühlenden Bauelement und dem Kühlkörper herzustellen, wird das Bauelement üblicherweise auch gegen den Kühlkörper gepresst. Dazu können z.B. Federbleche eingesetzt werden, welche beispielsweise auf den zu kühlenden Bauelementen angeordnet und mittels Schrauben oder Klammern befestigt werden. Die Federbleche bewirken dann z.B. eine Anpresskraft, welche die Bauelemente gegen die Trägerplatte und damit gegen den an der Unterseite der Trägerplatte angeordneten Kühlkörper presst. Die Verwendung von Federblechen zum Anpressen von Bauelementen weist allerdings den Nachteil auf, dass eine Montage meist manuell durchgeführt werden muss und mit relativ großem Aufwand verbunden ist.

Vor allem bei elektrischen Geräten, wie z.B. Schaltnetzteilen oder bei leistungselektronischen Schaltungen sind weiterhin üblicherweise vorgegebene Spannungsabstände bzw. Mindestabstände für so genannte Luft- und Kriechstrecken zwischen leitenden Teilen der Schaltung zu berücksichtigen. D.h. es sind z.B. aus Sicherheits- und/oder funktionstechnischen Gründen Mindestabstände zwischen z.B. Leiterbahnen, Bauelementkontaktierungen und weiteren leitenden Teilen wie z.B. Kühlkörpern, Befestigungsmitteln und auch Federblechen zum Anpressen von Bauelementen einzuhalten, um beispielsweise Personen oder Geräte vor Auswirkungen von elektrischer Spannung und/oder Strom bestmöglich zu schützen. Derartige Mindestabstände sind beispielsweise in Normen wie z.B. in der Europäische Norm EN 60 664-1, etc. vorgegeben. Dies führt dazu, dass beim Einsatz von Federblechen zum Anpressen von Bauelementen zum Erreichen der notwendigen bzw. vorgegebenen Spannungsabständen bzw. Luft- und Kriechstrecken beispielsweise relativ große Abstände bei der Anordnung der Bauelemente auf der Trägerplatte notwendig sind. Alternativ oder zusätzlich können die Spannungsabstände auch durch einen Einbau von Isolierungsfolien und/oder Isolierungselementen z.B. zwischen Federblech und Bauelement sichergestellt werden. Dies führt einerseits zu einem höheren Platzbedarf für die Schaltung. Andererseits wird dadurch die Montage relativ zeitaufwendig und komplex, da insbesondere für das Anpressen der Bauelemente neben dem Federblech noch zusätzliche Elemente zum Isolieren notwendig sind. Eine kostengünstige und gegebenfalls automatisierte Durchführung der Montage der Schaltung bzw. der Federbleche ist damit kaum mehr möglich.

### Darstellung der Erfindung

Der Erfindung liegt daher die Aufgabe zugrunde, eine Vorrichtung zum Anpressen für Bauelemente an einen Kühlkörper anzugeben, welche einfach und kostengünstig mit geringem Zeitaufwand montierbar ist und eine platzsparende Anordnung der Bauelemente unter Einhaltung von vorgegebenen Spannungsabständen ermöglicht.

Diese Aufgabe wird durch eine Vorrichtung der eingangs beschriebenen Art mit den Merkmalen des unabhängigen Anspruchs gelöst. Vorteilhafte Ausführungsformen der vorliegenden Erfindung sind in den abhängigen Ansprüchen beschrieben. Erfindungsgemäß erfolgt die Lösung der Aufgabe durch eine Vorrichtung der eingangs beschriebenen Art zum Anpressen von Bauelementen, welche auf einer Trägerplatte angeordnet und angebracht sind, an einen Kühlkörper. Dabei erfolgt eine Kühlung der Bauelemente über die Trägerplatte und/oder eine Kontaktierung der Bauelemente. Der Kühlkörper ist dazu an einer im Bereich der zu kühlenden Bauelemente nicht mit Bauelementen bestückten Seite bzw. Unterseite der Trägerplatte angeordnet. Dazu umfasst die erfindungsgemäße Vorrichtung zumindest einen Hohlkörper und zumindest einen Federarm. Der Hohlkörper ist zumindest zum Aufnehmen eines Befestigungskörpers eingerichtet, welcher beispielsweise direkt auf dem Kühlkörper angebracht sein kann und mit welchem die Vorrichtung befestigbar ist. Weiterhin weist die Vorrichtung einen Federarm auf, welcher gekrümmt ist und ein Ende des Federarms eine Auflagefläche zum Übertragen einer Anpresskraft auf ein zu kühlendes Bauelement aufweist.

Der Hauptaspekt der erfindungsgemäß vorgeschlagenen Lösung besteht darin, dass die Vorrichtung einfach und zeitsparend - in einer relativ kurzen Montagezeit - auf der Trägerplatte bzw. bei der Fertigung bzw. Montage der Schaltung bzw. des elektrischen Gerätes angebracht werden kann. Insbesondere ist die Vorrichtung für eine automatisierte Montage geeignet. Weiterhin ermöglicht die Vorrichtung - vor allem durch die Ausgestaltung des zumindest einen Federarm - eine platzsparende Anordnung der Bauelemente auf der Trägerplatte und damit eine platzsparende Ausgestaltung der Schaltung. Insbesondere bei elektrischen Geräten, wie z.B. Schaltnetzteilen, etc. und leistungselektronischen Schaltungen ermöglicht die Vorrichtung - insbesondere durch den Hohlkörper - trotz platzsparender Anordnung der zu kühlenden Bauelemente eine Einhaltung der vorgegebenen Spannungsabstände bzw. von vorgegebenen Mindestabständen für Luft- und Kriechstrecken zwischen einer Bauelementkontaktierung und dem Kühlkörper.

Insbesondere zum Einhalten dieser vorgegebenen Mindestabstände für Luft- und Kriechstrecken sowie aus Betriebssicherheitsgründen ist es von Vorteil, wenn die Vorrichtung derart ausgestaltet ist, dass in einem montierten Zustand ein vorgegebener Mindestspannungsabstand bzw. ein vorgegebener Mindestabstand für die Kriechstrecke zwischen einer Kontaktierung des zu kühlenden Bauelements und dem Befestigungskörper und/oder einem Befestigungsmittel zum Fixieren der Vorrichtung an der Trägerplatte eingehalten wird. Als Kriechstrecke wird dabei eine kürzeste Entfernung entlang einer Oberfläche eines festen Isolierstoffs zwischen zwei leitenden Teilen wie z.B. Leiterbahnen auf der Trägerplatte bzw. einer Kontaktierung oder Durchkontaktierung eines Bauelements und z.B. eines Befestigungskörpers bzw. eines Befestigungsmittels aus Metall.

Idealerweise ist zumindest der Federarm zumindest viertelkreisförmig gekrümmt ausgestaltet. Durch diese Ausgestaltung kann sehr einfach die Anpresskraft über die Auflagefläche an das Bauelement übertragen werden. Die Krümmung des Federarms hat dabei die Aufgabe einen ausreichenden Federweg bereit zu stellen und dabei zu ermöglichen, dass zu kühlenden Bauelemente so nahe aneinander bzw. an spannungsführende Teile (z.B. Leiterbahnen, etc.) unter Einhaltung vorgegebener Spannungs- bzw. Sicherheitsabstände angeordnet werden können. Der zumindest eine Federarm weist außerdem eine relativ hohe mechanische Belastbarkeit auf und ist platzsparend.

Besonders günstig hat sich eine Omega-ähnlich gekrümmte Ausgestaltung des Federarms erwiesen, durch welche sehr geringe Abstände von zu kühlenden Bauelementen zueinander und/oder von spannungsführenden Teilen bei gleichzeitiger Einhaltung der vorgegebenen Spannungsabständen sowie eine gute Anpressung zu kühlender Bauelemente ermöglicht werden. Weiterhin ist die Vorrichtung aufgrund eines Omega-förmigen Federarms, aber vor allem bei zwei oder mehr Omega-förmigen Federarmen bei einer automatisierten Montage z.B. mittels eines Roboterarms leicht greifbar und platzierbar.

Der Federarm kann idealerweise einen kreisförmigen oder quadratischen oder rechteckigen Querschnitt aufweisen. Dadurch kann die Anpresskraft beispielsweise über eine kreisförmige oder quadratische Fläche - eher konzentriert - oder über eine rechteckige Fläche verteilt an das zu kühlende Bauelement übertragen werden bzw. die Auflagefläche z.B. an eine Bauelementgröße angepasst werden.

Bei einer vorteilhaften Ausgestaltung der erfindungsgemäßen Vorrichtung ist weiterhin vorgesehen, dass die Auflagefläche am Ende des zumindest einen Federarms als polygonförmige Abplattung ausgeführt ist. Dadurch wird die Anpresskraft gleichmäßig auf das zu kühlende bzw. anzupressende Bauelement übertragen. Das Bauelement wird dadurch auf einfache Weise flächig gegen den Kühlkörper gedrückt und kann beispielsweise über seine gesamte Fläche gekühlt werden.

Es ist weiterhin günstig, wenn der Hohlkörper der erfindungsgemäßen Vorrichtung derart ausgestaltet ist, dass ein Befestigungsmittel einbringbar ist, welches für eine Montage mit dem Befestigungskörper lösbar oder unlösbar verbindbar ist. Der Hohlkörper kann dazu eine Bohrung aufweisen, in welcher das Befestigungsmittel (z.B. Schraube, Niete) eingebracht werden kann. Das Befestigungsmittel kann dann bei der Montage der erfindungsgemäßen Vorrichtung mit dem im Inneren des Hohlkörpers befindlichen Befestigungskörper, der z.B. auf dem Kühlkörper angebracht ist, verbunden werden.

Bei einer zweckmäßigen Ausgestaltung der erfindungsgemäßen Vorrichtung ist ein Innendurchmesser des Hohlkörpers derart ausgestaltet ist, dass zwischen einer Innenwand des Hohlkörpers und dem Befestigungskörper eine Isolierung einfügbar ist.

Weiterhin weist der Hohlkörper der erfindungsgemäßen Vorrichtung einen Verdrehschutz auf, durch welchen auf einfache Weise ein Verdrehen der Vorrichtung beim Platzieren und Befestigen verhindert wird. Damit wird vor allem eine automatisierte Montage erleichtert und vereinfacht.

Es ist zweckmäßig, wenn die Vorrichtung einteilig aus elastischem Material - idealerweise als Kunststoffspritzgussteil - ausgeführt ist. Damit wird die Montage verkürzt und vereinfacht, da nur ein Teil zum Anpressen von zumindest einem Bauelement angebracht werden muss. Dadurch werden die Montagekosten reduziert und es können die Geräte bzw. Schaltungen platzsparender, rascher und kostengünstiger hergestellt werden. Außerdem führt die Verwendung eines elastischen Material - vor allem Kunststoff - für die Vorrichtung beim Einsatz in einem elektrischen Geräte zu keinen direkten EMV-Auswirkungen - d.h. es treten damit durch die Vorrichtung keine ungewollten elektrischen und/oder elektromagnetischen Effekte auf, welche die Funktionsweise des elektrischen Geräts stören könnten. Weiterhin ist insbesondere bei Verwendung von Hochleistungskunststoffen (z.B. Polythermid bzw. PEI, Polyamidimid bzw. PAI), welche eine hohe Temperaturbeständigkeit aufweisen, über einen weiten Temperaturbereich für eine federnde Wirkung der Vorrichtung gesorgt - d.h. durch die Vorrichtung wird das jeweilige zu kühlende Bauelement mit dem entsprechenden Anpressdruck über einen weiten Temperaturbereich gegen den Kühlkörper gedrückt.

### Kurzbeschreibung der Zeichnung

Die Erfindung wird nachfolgend in beispielhafter Weise anhand der beigefügten Figuren erläutert. Dabei zeigen:
- Figur 1: schematisch eine beispielhafte Ausführungsform der erfindungsgemäßen Vorrichtung zum Anpressen von Bauelementen an einen Kühlkörper
- Figur 2: schematisch eine weitere, beispielhafte Ausführungsform der erfindungsgemäßen Vorrichtung zum Anpressen von Bauelementen an einen Kühlkörper mit zwei Federarmen
- Figur 3: schematisch und beispielshaft eine Ausführungsform der erfindungsgemäßen Vorrichtung zum Anpressen von Bauelementen in einem montierten Zustand

### Ausführung der Erfindung

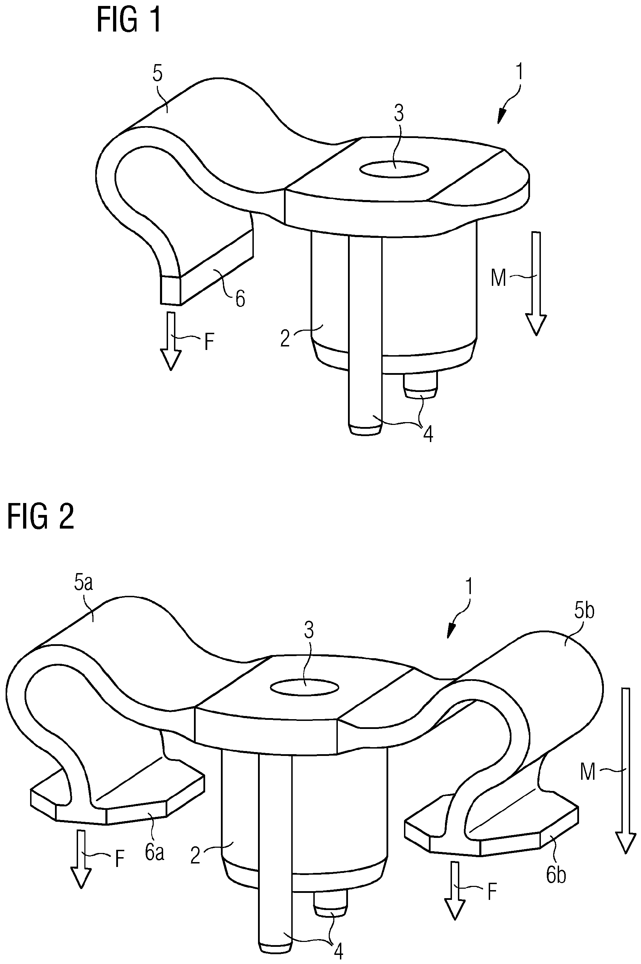

Figur 1 zeigt in schematischer Weise eine beispielhafte Ausführungsform der erfindungsgemäßen Vorrichtung 1 zum Anpressen eines auf einer Trägerplatte bzw. Leiterplatte 8 angebrachten Bauelements 7a, 7b an einen Kühlkörper 9 in einer Schrägansicht. Die Vorrichtung 1 ist einteilig aus einem elastischen und gegebenenfalls isolierenden Material ausgeführt und kann z.B. mittels eines Spritzgussverfahrens als Kunststoffspritzgussteil hergestellt werden.

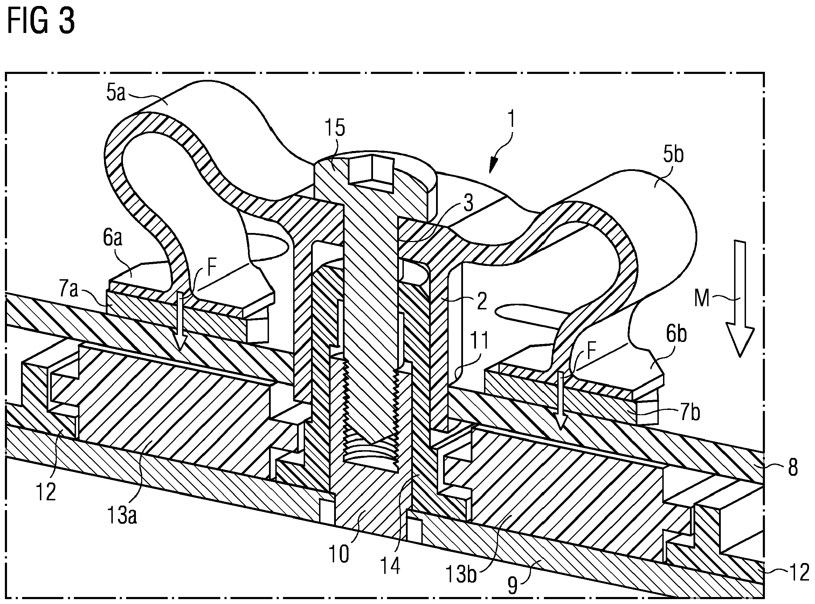

Die Vorrichtung 1 umfasst einen Hohlkörper 2, welcher beispielsweise als Hohlzylinder ausgeführt sein kann. Alternativ kann der Hohlkörper 2 auch einen quadratischen oder rechteckigen Querschnitt aufweisen. Der Hohlkörper ist zum Aufnehmen zumindest eines Befestigungskörpers 10 - wie anhand von Figur 3 noch genauer erläutert wird - eingerichtet. Dabei ist ein Innendurchmesser des Hohlkörpers 2 so ausgestaltet, dass zumindest der Befestigungskörper 10 in den Hohlkörper 2 eingefügt werden kann. Gegebenenfalls kann der Innendurchmesser des Hohlkörpers 2 derart ausgestaltet sind, dass z.B. für eine höhere Durchschlagfestigkeit bzw. zur Vergrößerung eines Spannungsabstandes zwischen einer Kontaktierung des Bauelements 7a, 7b und dem Befestigungskörper 10 noch eine Isolierung 14 eingefügt werden kann.

Weiterhin weist der Hohlkörper 2 auf einer in Montagerichtung M oberen Seite einen Auslass 3 auf. In diesen Auslass 3 kann bei der Montage ein Befestigungsmittel 15 (z.B. eine Schraube oder eine Niete) eingebracht werden, welches mit dem Befestigungskörper 10 lösbar oder unlösbar verbindbar ist. Durch das Einbringen des Befestigungsmittels 15 bzw. durch die Verbindung zwischen Befestigungsmittel 15 und Befestigungskörper 10 wird die Vorrichtung 1 befestigt und das Bauelement 7a, 7b durch eine Anpresskraft F gegen die Trägerplatte 8 bzw. den Kühlkörper 9 gepresst. Für ein einfaches Platzieren und Montieren der Vorrichtung 1 weist der Hohlkörper 2 einen Verdrehschutz 4 auf, welcher über ein in Montagerichtung M unteres Ende des Hohlkörpers hinausragt und z.B. in entsprechende Auslässe der Trägerplatte 8 eingreifen kann.

Weiterhin weist die Vorrichtung 1 einen Federarm 5 auf, welcher gekrümmt ausgestaltet ist. Der in Figur 1 dargestellte Federarm 5 ist beispielsweise Omega-förmig bzw. ähnlich dem griechischen Großbuchstaben Omega Q geformt. Der Federarm 5 kann im einfachsten Fall zumindest viertelkreisförmig gekrümmt sein. Der Federarm 5 geht in die in Montagerichtung M obere Fläche des Hohlkörpers 2 über. An einem Ende weist der Federarm 5 eine Auflagefläche 6 auf, über welche im montierten Zustand die Anpresskraft F auf das zu kühlende Bauelement 7a, 7b übertragen wird. Die Auflagefläche 6 kann beispielsweise je nach Ausgestaltung des Federarms 5 kreisförmig, quadratisch oder wie in Figur 1 beispielhaft dargestellt rechteckig sein. Alternativ kann das Ende des Federarms 5 auch als polygonförmige Abplattung ausgestaltet sein.

In Figur 2 ist eine weitere vorteilhafte Ausführungsform der erfindungsgemäßen Vorrichtung 1 zum Anpressen von Bauelementen 7a, 7b an einen Kühlkörper 9 beispielhaft und schematisch in einer Schrägansicht dargestellt. Die in Figur 2 dargestellte Ausführungsform der Vorrichtung 1 umfasst ebenfalls einen Hohlkörper 2 zum Aufnehmen des Befestigungskörpers 10. Der Hohlkörper ist z.B. wieder als Hohlzylinder ausgeführt und weist einen Auslass 3 auf, in welchen ein Befestigungsmittel 15 einbringbar ist. Weiterhin ist am Hohlkörper 2 wieder ein Verdrehschutz 4 für einfaches Platzieren und Montieren vorgesehen.

Die in Figur 2 dargestellte Aufführungsform der Vorrichtung 1 weist allerdings zwei Federarme 5a, 5b auf, über welche zwei Bauelemente 7a, 7b an einen Kühlkörper 8 angepresst werden können. Die Federarme 5a, 5b gehen in die in Montagerichtung M obere Fläche des Hohlkörpers 2 über und weisen z.B. jeweils eine Omega-förmig gekrümmte Ausgestaltung auf. Durch die Omega-ähnliche Formung der Federarme 5a, 5b können z.B. die zu kühlenden Bauelemente 7a, 7b in relativ geringen Abständen zueinander auf der Träger- bzw. Leiterplatte 8 angeordnet werden. Jeder der Federarme 5a, 5b weist an seinem Ende eine Auflagefläche 6a, 6b auf, über welche die Anpresskraft F auf das jeweils zu kühlende Bauelement 7a, 7b übertragen wird. Dabei sind beispielsweise für eine bessere Übertragung der Anpresskraft F auf das jeweilige Bauelement 7a, 7b die Auflageflächen 6a, 6b als polygonförmige Abplattungen ausgestaltet.

Die in Figur 2 dargestellte Vorrichtung 1 kann beispielsweise wieder als einteiliger Kunststoffspritzgussteil aus einem elastischen und gegebenfalls isolierenden Material hergestellt werden. Weiterhin ist es denkbar, dass die Vorrichtung 1 - je nach Bedarf und/oder Anordnung der zu kühlenden Bauelemente 7a, 7b auch drei, vier oder mehr Federarme 5a, 5b aufweist.

Figur 3 zeigt die in Figur 2 beispielshaft dargestellte Ausführungsform der Vorrichtung 1 mit zwei Federarmen 5a, 5b in einem montierten Zustand in einem Längsschnitt durch den Hohlkörper 2.

Die zu kühlenden Bauelemente 7a, 7b sind auf der Trägerplatte bzw. Leiterplatte 8 angebracht. An einer zumindest im Bereich der zu kühlenden Bauelemente 7a, 7b bzw. in einem Kühlbereich nicht bestückten Seite der Trägerplatte 8 ist der Kühlkörper 9 angeordnet, wobei der Kühlkörper 9 den Befestigungskörper 10 zum Anbringen der Vorrichtung 1 zum Anpressen der Bauelemente 7a, 7b aufweist. Die Trägerplatte 8 weist z.B. zwischen den Bauelementen 7a, 7b einen Auslass 11 auf, in welchen der Befestigungskörper 10 für die erfindungsgemäße Vorrichtung 1 - entgegen der Montagerichtung M der Vorrichtung - einbringbar ist. Für eine galvanische Trennung der Trägerplatte 8 bzw. der Kontakte, insbesondere einer Durchkontaktierungen, der Bauelemente 7a, 7b vom Kühlkörper 9, welcher aus Metall, insbesondere Aluminium, ausgeführt sein kann, können zwischen der im Kühlbereich nicht bestückten Seite bzw. Unterseite der Trägerplatte 8 und dem Kühlkörper 9 eine Isolierungsschicht 12 bzw. unterhalb der Bauelemente 7a, 7b Isolierelemente 13a, 13b angeordnet sein.

Bei einer Montage wird die Vorrichtung 1 in der Montagerichtung M mit dem Hohlkörper 2 in den Auslass 11 in der Trägerplatte 8 eingebracht. Dabei kommen die Enden der Federarme 5a, 5b mit den Auflageflächen 6a, 6b auf den zu kühlenden Bauelementen 7a, 7b zum Liegen und der Hohlkörper 2 nimmt zumindest den Befestigungskörper 10 auf. Weiterhin kann zwischen einer Innenwand des Hohlkörpers 2 und dem Befestigungskörper 10 noch eine Isolierung 14 eingefügt sein. Der Innendurchmesser des Hohlkörpers 2 ist dann derart ausgestaltet, dass sowohl der Befestigungskörper 10 als auch die Isolierung 14 aufgenommen werden kann.

Durch den Auslass 3 an der oberen Seite des Hohlkörpers 2 wird dann in Montagerichtung M ein Befestigungsmittel 15 (z.B. Schraube, Niete) eingebracht und mit dem Befestigungskörper 10 verbunden. Durch diese Verbindung wird über die Auflageflächen 6a, 6b an den Enden der Federarme 5a, 5b die Anpresskraft F auf die Bauelemente 7a, 7b übertragen. D.h. die Bauelemente 7a, 7b werden nach Fixierung der Vorrichtung 1 mit der Anpresskraft F, welche von den Federarmen 5a, 5b ausgeübt wird, gegen die Trägerplatte 8 und damit gegen den Kühlkörper 9 gepresst.

Weiterhin ist die Vorrichtung 1, insbesondere der Hohlkörper 2, derart ausgestaltet, dass ein vorgegebener Mindestspannungsabstand bzw. eine vorgegebene Mindestlänge für eine Kriechstrecke zwischen der Kontaktierung bzw. Durchkontaktierung der Bauelemente 7a, 7b und dem metallischen Befestigungskörper 10 und/oder dem Befestigungsmittel 15 eingehalten wird.

### Bezugszeichenliste

- 1: Vorrichtung zum Anpressen von Bauelementen
- 2: Hohlkörper
- 3: Auslass zum Einbringen eines Befestigungsmittels
- 4: Verdrehschutz
- 5, 5a, 5b: Federarm
- 6, 6a, 6b: Auflagefläche
- 7a, 7b: Bauelemente
- 8: Trägerplatten bzw. Leiterplatten
- 9: Kühlkörper
- 10: Befestigungskörper
- 11: Auslass in der Träger- bzw. Leiterplatte
- 12: Isolierungsschicht
- 13a, 13b: Isolierelemente
- 14: Isolierung
- 15: Befestigungsmittel
- F: Anpresskraft
- M: Montagerichtung

## Patentansprüche

1. Vorrichtung zum Anpressen von Bauelementen (7a, 7b), welche auf einer Trägerplatte (8) angebracht sind, an einen Kühlkörper (9), wobei der Kühlkörper (9) an einer Seite der Trägerplatte (8) angeordnet ist, welche zumindest in einem Kühlbereich keine Bauelemente (7a, 7b) aufweist, und wobei die Bauelemente (7a, 7b) zumindest durch die Trägerplatte (8) entwärmbar sind, **dadurch gekennzeichnet, dass** die Vorrichtung (1) zumindest einen Hohlkörper (2) zum Aufnehmen von zumindest einem Befestigungskörper (10) und zumindest einen Federarm (5, 5a, 5b) umfasst, wobei der Federarm (5, 5a, 5b) gekrümmt ist und ein Ende des Federarms (5, 5a, 5b) eine Auflagefläche (6, 6a, 6b) zum Übertragen einer Anpresskraft (F) auf ein zu kühlendes Bauelement (7a, 7b) aufweist.

2. Vorrichtung nach Anspruch 1, **dadurch gekennzeichnet, dass** die Vorrichtung (1) derart ausgestaltet ist, dass in einem montierten Zustand ein vorgegebener Mindestspannungsabstand zwischen einer Kontaktierung des kühlenden Bauelements (7a, 7b) und dem Befestigungskörper (10) und/oder einem Befestigungsmittel (15) eingehalten wird.

3. Vorrichtung nach einem der Ansprüche 1 bis 2, **dadurch gekennzeichnet, dass** der zumindest eine Federarm (5, 5a, 5b) zumindest viertelkreisförmig, insbesondere Omega-förmig, gekrümmt ausgestaltet ist.

4. Vorrichtung nach einem der Ansprüche 1 bis 3, **dadurch gekennzeichnet, dass** der zumindest eine Federarm (5, 5a, 5b) einen kreisförmigen oder quadratischen oder rechteckigen Querschnitt aufweist.

5. Vorrichtung nach einem der Ansprüche 1 bis 4, **dadurch gekennzeichnet, dass** die Auflagefläche (6a, 6b) am Ende des zumindest einen Federarms (5, 5a, 5b) als polygonförmige Abplattung ausgeführt ist.

6. Vorrichtung nach einem der Ansprüche 1 bis 5, **dadurch gekennzeichnet, dass** der Hohlkörper (2) derart ausgestaltet ist, dass das Befestigungsmittel (15) einbringbar ist, welches mit dem Befestigungskörper (10) lösbar oder unlösbar verbindbar ist.

7. Vorrichtung nach einem der Ansprüche 1 bis 6, **dadurch gekennzeichnet, dass** ein Innendurchmesser des Hohlkörpers (2) derart ausgestaltet ist, dass zwischen einer Innenwand des Hohlkörpers (2) und dem Befestigungskörper (10) eine Isolierung (14) einfügbar ist.

8. Vorrichtung nach einem der Ansprüche 1 bis 7, **dadurch gekennzeichnet, dass** der Hohlkörper (2) weiterhin einen Verdrehschutz (4) aufweist.

9. Vorrichtung nach Anspruch 1 bis 8, **dadurch gekennzeichnet, dass** die Vorrichtung (1) einteilig aus elastischem Material ausgeführt ist.

10. Vorrichtung nach einem der Ansprüche 1 bis 9, **dadurch gekennzeichnet, dass** die Vorrichtung (1) als Kunststoffspritzteil ausgeführt ist.
